(19) Europäisches Patentamt
European Patent Office
Office européen des brevets

(11) Veröffentlichungsnummer: **0 204 292 B1**

# (12) EUROPÄISCHE PATENTSCHRIFT

(45) Veröffentlichungstag der Patentschrift: **29.05.91**

(51) Int. Cl.$^5$: **G03F 7/038**

(21) Anmeldenummer: **86107428.4**

(22) Anmeldetag: **02.06.86**

## (54) Verfahren zum Herstellen von gedruckten Schaltungen unter Verwendung eines durch Strahlung vernetzenden Fotopolymersystems.

(30) Priorität: **05.06.85 DE 3520277**

(43) Veröffentlichungstag der Anmeldung:
**10.12.86 Patentblatt 86/50**

(45) Bekanntmachung des Hinweises auf die Patenterteilung:
**29.05.91 Patentblatt 91/22**

(84) Benannte Vertragsstaaten:
**CH DE FR GB IT LI NL**

(56) Entgegenhaltungen:
**EP-A- 0 030 213**
**EP-A- 0 174 494**
**DE-A- 2 355 891**
**DE-A- 2 408 893**
**DE-B- 1 104 339**
**US-A- 3 738 973**
**EP-A- 0 167 051**
**DE-A- 2 222 472**
**DE-A- 2 365 319**
**DE-A- 2 635 929**
**FR-A- 2 259 863**

**PATENT ABSTRACTS OF JAPAN, Band 6, Nr. 195 (P-146)[1073], 5. Oktober 1982; & JP-A-57 105 736 (DAICEL K.K.) 01-07-1982**

(73) Patentinhaber: **Siemens Aktiengesellschaft**
**Wittelsbacherplatz 2**
**W-8000 München 2(DE)**

(72) Erfinder: **Nuyken, Oskar, Dr.**
**Ignaz-Günther-Strasse 12**
**W-8000 München 81(DE)**
Erfinder: **Melchior, Walter, Dipl.-Chem.**
**Bergkieferweg 4**
**W-8000 München 45(DE)**
Erfinder: **Budde, Klaus, Dr.**
**Ottobrunner Strasse 5**
**W-8025 Unterhaching(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 204 292 B1

## Beschreibung

Die Erfindung betrifft ein Verfahren zum Herstellen von gedruckten Schaltungen, insbesondere im Mehrlagenaufbau, wie sie in der Mikroelektronik verwendet werden, bei dem

a) ein durch Strahlung vernetzendes Fotopolymersystem auf das, insbesondere als Metallträgerfolie ausgebildete Substrat aufgebracht wird,

b) die gewünschte Verdrahtungsstruktur durch Belichtung und Herauslösung der unbelichteten Teile in der Polymerschicht erzeugt wird und gegebenenfalls

c) das freigelegte Metall durch Galvanisieren oder stromlose Metallisierung verstärkt wird.

Solche Verfahren sind in den deutschen Patentanmeldungen P 34 24 119.1 und P 34 29 606.9 vorgeschlagen worden. Bei dem in der Pat. Anm. P 34 24 119.1 beschriebenen Verfahren werden als Ausgangsprodukte für die Polymerisation zur Verkürzung der Belichtungszeit von strahlungsempfindlichen Kunstharzlacken Zimtsäure-Epichlorhydrin-Bisphenol A-Verbindungen verwendet, die reaktive Hydroxy- oder Hydroxymethylengruppen am Bisphenolbaustein enthalten.

Die thermische Belastbarkeit von Produkten dieser Verbindungen ist zwar sehr hoch, doch zeigen sich bei homopolymerisierten Verbindungen nur geringe Löslichkeiten in üblichen organischen Lösemitteln, was eine aufwendige Verarbeitung erfordert. Zudem nachteilig ist hier eine geringe Lagerstabilität der unbelichteten Materialien.

Bei dem in der Pat. Anm. P 34 29 606.9 beschriebenen Verfahren werden zur Erzielung einer niedrigen Dielektrizitätskonstante und zur Verbesserung der Dauertemperaturbeständigkeit Polymersysteme auf Kunstharzlackbasis verwendet, bei denen als Ausgangsstoffe für die Umsetzung mit den strahlungsempfindlichen Substanzen lineare Fluorpolymere mit mindestens zwei reaktiven Endgruppen pro Polymermolekül eingesetzt werden. Die Umsetzung der fluorierten Ausgangsstoffe und die Verknüpfung mit den fotoreaktiven Substanzen geschieht in mehreren Verfahrensschritten und in aufwendiger Weise, bedingt durch die zu verwendenden, meist teilfluorierten Lösemittel, die speziell beim späteren Mehrlagenaufbau eine aufwendige Verarbeitungstechnik erfordern.

Der Erfindung liegt die Aufgabe zugrunde, ein Verfahren zur Herstellung gedruckter Schaltungen im Mehrlagenaufbau für mikroelektronische Komponenten anzugeben, welches aus einfachen Verfahrensschritten besteht und ein Produkt liefert, welches durch die Verwendung des Fotopolymers auf den Zusatz eines Härtungsmittels und damit auch auf den Prozeßschritt der Heißhärtung bzw. Temperung des belichteten Substrates verzichten kann. Das Verfahren soll auch für den Einsatz bei der Herstellung von integrierten Halbleiterschaltungen in VLSI ( = very large scale integration)-Technik anwendbar sein.

Diese Aufgabe wird durch ein Verfahren der eingangs genannten Art dadurch gelöst,

- daß als Fotopolymer ein Epoxidharz mit einem Molekulargewicht kleiner 15000 verwendet wird, welches durch Umsetzung eines Epoxidharzes auf der Basis von Bisphenol A mit Epoxy-Endgruppen mit 3-(2-Furyl)-acryl-säurechlorid erhältlich ist,
- daß die Vernetzung des Fotopolymers mit Licht der Wellenlänge im Bereich von 150 bis 400 nm in Gegenwart eines Fotosensibilisators und ohne anschließende Heißhärtung durchgeführt wird,
- und daß unmittelbar auf der so hergestellten ersten Schicht ohne besondere Vorbehandlung weitere Schichten (Lagen) von Verdrahtungsstrukturen durch Auftragen von Fotopolymer und Durchführen der Verfahrensschritte b) und c) erzeugt werden.

Bevorzugt wird ein Wellenlängenbereich von 300 - 400 nm angewendet.

Es liegt im Rahmen der Erfindung, Sensibilisatoren, Fotoinitiatoren und auch Co-Sensibilisatoren in Konzentrationen im Bereich von 0,5 bis 5 % dem lichtempfindlichen Polymer zuzusetzen.

Als Sensibilisatoren oder Fotoinitiatoren kommen bevorzugt Derivate von Benzophenon, Benzoin oder Acetoptenon in Betracht, als Co-Sensibilisatoren können tertiäre Amine verwendet werden.

Ebenso liegt die Verwendung von reaktiven Verdünnern, bevorzugt auf Acrylatbasis, und im Konzentrationsbereich von 5 - 30 Gewichts-%, bezogen auf das Basispolymer, im Rahmen der Erfindung.

Die Umsetzung und Vernetzung eines Furylacrylsäureveresterten Epoxidharzes geschieht in folgender Weise:

Umsetzung des Epoxidharzes (zum Beispiel Araldit$^{R}$ GT 6099) mit lichtempfindlichen Gruppen

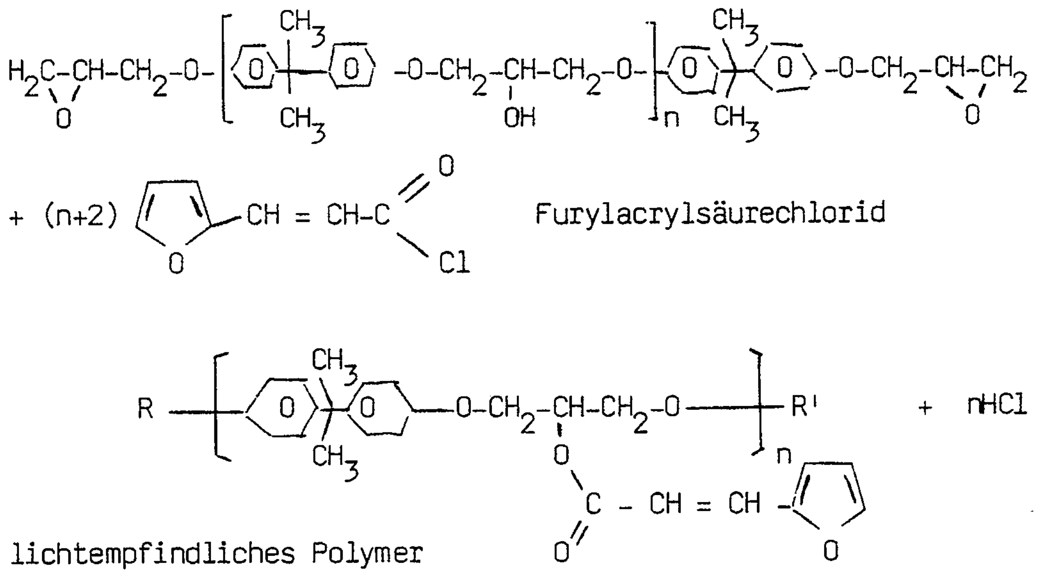

Furylacrylsäurechlorid

lichtempfindliches Polymer

Bei Bestrahlung mit UV-Licht tritt in bekannter Weise eine Vernetzung des lichtempfindlichen Polymers durch Reaktion der acrylatischen C = C-Doppelbindung ein.

In der FR-A-2 259 863 wird ein mit Furanacrylsäure verestertes Phenoxyharz beschrieben, welches für gedruckte Schaltungen und lithographische Platten Verwendung finden kann.

Aus der US-A-3 738 ist ein Harz auf Bisphenol-A-Basis mit Phenoxyendgruppen für gedruckte Schaltungen bekannt.

Aus der DE-A- 2 355 sind als Resistmaterial geeignete lichtempfindliche Polymere bekannt.

Zwar ist aus der DE-OS 26 35 929 ein fotopolymerisierbares Epoxidharz bekannt; doch ist hier zur Vernetzung ein Heißhärtungsmittel erforderlich; der Mehrlagenaufbau erfolgt durch Verpressen.

Auch aus der DE-PS 23 42 407 ist eine gedruckte Schaltung mit lichtempfindlichen Epoxidharzgruppen zu entnehmen; doch geschieht auch hier die Vernetzung unter Verwendung eines in der Wärme wirkenden Härters. Außerdem wird die Mehrlagenschaltung durch Verpressen hergestellt.

Die DE-PS 24 08 893 enthält eine durch Strahlung härtbare Masse auf der Basis von Polycarbonsäureveresterten Epoxidverbindungen; diese härtbare Masse wird nicht zur Strukturerzeugung und damit zur Herstellung von gedruckten Schaltungen, sondern als Anstrichmaterial und zur Erzeugung von Druckfarben verwendet.

Aus der DE-PS 11 04 339 und der DE-OS 25 03 526 sind lichtempfindliche Epoxycinamate bzw. Phenoxyacrylate zur Herstellung von Flachdruckplatten und Kopierschichtträgern bekannt.

Dort liegt der Schwerpunkt jedoch auf der Erzeugung hoher Molekulargewichte im Basispolymeren (wenigstens 20.000 bzw. 15.000) und dem Verzicht auf Sensibilisierungsmittel. Reaktive Verdünner werden nicht genannt. Die Anforderungen, die an diese Produkte gestellt werden, sind ganz anderer Art als bei der Erfindung.

Durch die Erfindung wird ein Produkt erhalten, welches gegenüber bekannten Produkten folgende Eigenschaften und Vorteile aufweist:

1. die Dielektrizitätskonstante $\epsilon_r$ ist kleiner als 3,5; dies ermöglicht geringe Leiterbahnabstände;
2. die Glasübergangstemperatur des vernetzten Homopolymeren liegt bereits oberhalb 110° C; daraus folgt eine hohe Temperaturbeständigkeit;
3. es ergibt sich eine hohe UV-Empfindlichkeit, die etwa 5 bis 6 mal besser ist als bei den entsprechenden Zimtsäureverbindungen;
4. der Zusatz von reaktiven Verdünnern erlaubt die gezielte Einstellung der optimalen Werte der unter 1. bis 3. genannten Eigenschaften;
5. die gute Löslichkeit in organischen Lösungsmitteln ermöglicht eine einfache Verarbeitung,
6. beim Mehrlagenaufbau sind keine Zwischenschichten mehr erforderlich.

Im folgenden soll anhand eines Ausführungsbeispiels die Anwendung des erfindungsgemäßen Polymersystems zur Herstellung einer Mehrlagenverdrahtung beschrieben werden.

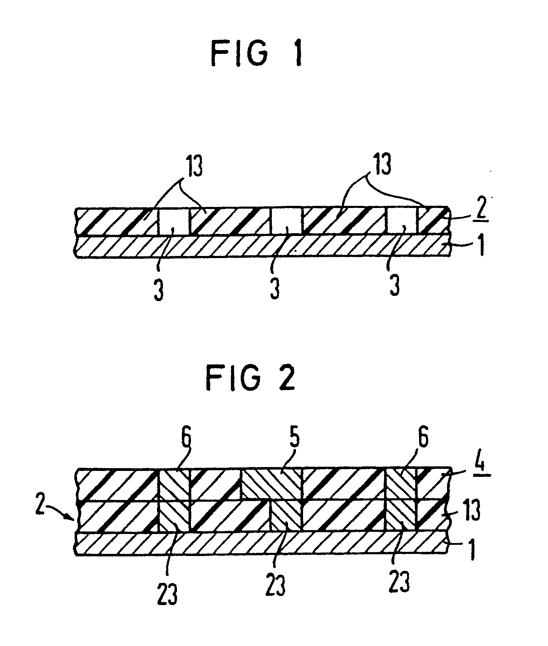

Die Figuren 1 und 2

zeigen dabei im Schnittbild die für die Erfindung wesentlichen Verfahrensschritte.

<u>Figur 1:</u>

Als Träger wird eine Kupferfolie 1 verwendet, auf die eine Schicht 2 des fotovernetzbaren Isolierstoffes gemäß der Lehre der Erfindung nach Zusatz von zum Beispiel Michler's Keton als Sensibilisator in einer Konzentration von zum Beispiel 1,5 % durch Tauchen oder Sprühbelacken, beispielsweise in einer Schichtdicke von 5 bis 20 µm aufgebracht wird. Die Schicht 2 wird mit UV-Strahlung in der Weise belichtet und entwickelt, daß die in ihr einzufügenden Durchkontaktierungen, das heißt die Anschlußpunkte der Chips, als Durchbrechungen 3 in der Isolierstoffschicht 2 entstehen. Die Bestrahlung erfolgt im Kontakt-oder Projektionsverfahren unter Verwendung einer Maske (nicht abgebildet), die den Bereich der Durchbrechungen 3 der Schicht 2 abdeckt (Negativlack). Die abgedeckten Teile 3 werden anschließend mit einem entsprechenden Lösungsmittel, wie zum Beispiel Toluol, Xylol, Ketone wie Methylethylketon, 2-Ethoxy-Ethyl-Acetat, chlorierte Kohlenwasserstoffe wie Trichloräthylen herausgelöst, während bei den belichteten Teilen 13 der Schicht 2 eine chemische Vernetzung eingetreten ist, die eine Lösung verhindert, so daß diese Teile 13 als Isolierstoffschicht verbleiben. Nach der Herstellung der Durchbrechungen 3 für die dieser ersten Isolierstoffschicht 2 (13) zugeordneten Durchkontaktierungen werden die Durchbrechungen 3 im Zusammenhang mit der als Träger dienenden Kupferfolie 1 mittels galvanischer Metallisierung mit einem elektrisch gut leitenden Material, beispielsweise Kupfer, ausgefüllt (23 in Figur 2). Figur 2:
Anschließend wird auf die, die Durchkontaktierungen 23 enthaltende Isolierstoffschicht 13 eine weitere Schicht 4 des fotovernetzbaren Isolierstoffes gemäß der Erfindung in der gleichen Weise wie bei Figur 1 beschrieben aufgebracht, in welche Leitungsbahnen 5 und weitere Durchkontaktierungen 6 eingefügt werden. Die Belichtung und Entwicklung der Schicht 4 erfolgt ebenfalls wie bei Figur 1 beschrieben. Außer den Durchbrechungen (6) für die Durchkontaktierung, die mit den Durchkontaktierungen 3 der ersten Isolierstoffschicht 2 (13) zur Auflage kommen, werden in der zweiten Isolierstoffschicht 4 grabenförmige Aussparungen 5 für die gewünschten Leitungsbahnen erzeugt, wobei diese Aussparungen 5 so angeordnet sind, daß mindestens eine Durchkontaktierung 23 der ersten Isolierstoffschicht (2, 13) in eine Aussparung 5 hineinragt. Zum Aufbau der Leitungsbahnen werden die Aussparungen 5 durch Galvanisieren mit einer Metallisierung versehen. Weitere Durchkontaktierungen und Leiterbahnen können dann durch entsprechende Wiederholung der vorstehend beschriebenen Herstellungsstufen aufgebracht werden. Auf den Zusatz eines Härtungsmittels und damit auf einen Aushärteprozeß kann verzichtet werden. Die Bestrahlung mit UV-Licht in Gegenwart des Fotosensibilisators führt zu einer ausreichenden Vernetzung bzw. Härtung des Polymeren.

Der Verdrahtungsaufbau erfordert keine Kupferzwischenschichten. Die geforderte hohe thermische Belastbarkeit ist gegeben; die Verarbeitung mit den bekannten Resisttechniken ist problemlos. Dadurch vereinfacht sich nicht nur das Verfahren zur Herstellung eines solchen Aufbaues, sondern auch die Zuverlässigkeit in bezug auf die elektrischen Daten der Schaltung.

Aus diesem Grunde und auch wegen der sehr niedrigen Dk und der guten Auflösung ist das erfindungsgemäße Polymersystem bestens geeignet als hochtemperaturbeständiger Negativlack bei der Herstellung von integrierten Halbleiterschaltungen in VLSI-Technik, bei denen dis Erzeugung maßgetreuer Mikrostrukturen bzw. -muster von großer Bedeutung ist.

## Ansprüche

**1.** Verfahren zum Herstellen von gedruckten Schaltungen im Mehrlagenaufbau, wie sie in der Mikroelektronik verwendet werden, bei dem

a) ein durch Strahlung vernetzendes Fotopolymersystem auf das insbesondere als Metallträgerfolie ausgebildete Substrat aufgebracht wird,

b) die gewünschte Verdrahtungsstruktur durch Belichtung und Herauslösung der unbelichteten Teile in der Polymerschicht erzeugt wird und gegebenenfalls

c) das freigelegte Metall durch Galvanisieren oder stromlose Metallisierung verstärkt wird,

**dadurch gekennzeichnet,**

- daß als Photopolymer ein Epoxidharz mit einem Molekulargewicht kleiner 15000 verwendet wird, welches durch Umsetzung eines Epoxidharzes auf der Basis von Bisphenol A mit Epoxy-Endgruppen mit 3-(2-Furyl)-acrylsäurechlorid erhältlich ist,
- daß die Vernetzung des Photopolymers mit Licht der Wellenlänge im Bereich von 150 bis 400 nm in Gegenwart eines Photosensibilisators und ohne anschließende Heißhärtung durchgeführt wird,
- und daß unmittelbar auf der so hergestellten ersten Schicht ohne besondere Vorbehandlung weitere Schichten (Lagen) von Verdrahtungsstrukturen durch Auftragen von Photopolymer und

Durchführen der Verfahrensschritte b) und c) erzeugt werden.

2. Verfahren nach Anspruch 1, **dadurch gekennzeichnet,** daß die Vernetzung im Wellenlängenbereich von 300 - 400 nm durchgeführt wird.

3. Verfahren nach Anspruch 1 oder 2, **dadurch gekennzeichnet,** daß Sensibilisatoren, Fotoinitiatoren und auch Co-Sensibilisatoren in Konzentrationen im Bereich von 0.5 bis 5 % dem lichtempfindlichen Polymer zugesetzt werden.

4. Verfahren nach Anspruch 3, **dadurch gekennzeichnet,** daß Derivate von Benzophenon, Benzoin oder Acetophenon, als Co-Sensibilisatoren tertiäre Amine verwendet werden.

5. Verfahren nach Anspruch 4, **dadurch gekennzeichnet,** daß als Sensibilisator Michler's Keton (4.4'-Bis (dimethyl amino)-benzophenon) verwendet wird.

6. Verfahren nach mindstens einem der Ansprüche 1 bis 5, **dadurch gekennzeichnet,** daß reaktive Verdünner, bevorzugt auf Acrylatbasis und im Konzentrationsbereich von 5 bis 30 Gewichts%, bezogen auf das Basispolymer, verwendet werden.

## Claims

1. Process for the manufacture of printed circuits, such as are used in microelectronics, by building up a multi-layer structure, in which
   a) a photopolymer system crosslinking by radiation is applied to the substrate formed especially as a metal carrier foil,
   b) the desired wiring structure is produced by exposure and dissolution of the unexposed areas in the polymer layer and, if appropriate,
   c) the bared metal is reinforced by electroplating or currentless metallisation,
   characterised in that
   - the photopolymer used is an epoxide resin having a molecular weight of less than 15,000, which is obtainable by reacting an epoxide resin based on bisphenol A and having epoxy end groups with 3-(2-furyl)-acrylic acid chloride,
   - the crosslinking of the photopolymer is effected by light of a wavelength in the region from 150 to 400 nm in the presence of a photosensitiser and without subsequent heat-curing and,
   - directly on the first layer thus produced, further layers (plies) of wiring structures are produced, without special pretreatment, by applying photopolymer and carrying out the process steps b) and c).

2. Process according to Claim 1, characterised in that the crosslinking is effected in the wavelength region of 300-400 nm.

3. Process according to Claim 1 or 2, characterised in that sensitisers, photoinitiators and also co-sensitisers are added to the light-sensitive polymer in concentrations in the range from 0.5 to 5%.

4. Process according to Claim 3, characterised in that derivatives of benzophenone, benzoin or acetophenone and, as co-sensitisers, tertiary amines are used.

5. Process according to Claim 4, characterised in that Michler's ketone (4,4'-bis(dimethylamino)-benzophenone) is used as the sensitiser.

6. Process according to at least one of Claims 1 to 5, characterised in that reactive diluents, preferably based on acrylate and in a concentration range from 5 to 30% by weight, relative to the base polymer, are used.

## Revendications

1. Procédé pour fabriquer des circuits imprimés selon une structure à couches multiples, du type utilisés dans le domaine de la micro-électronique, selon lequel
   a) on dépose un système de photopolymère, qui est réticulé sous l'effet d'un rayonnement, sur le substrat réalisé notamment sous la forme d'une feuille de support métallique,
   b) on produit la structure de câblage désirée par exposition et dissolution des parties non exposées dans la couche de polymère, et éventuellement
   c) on renforce le métal mis à nu, par galvanisation ou métallisation sans courant,
   caractérisé par le fait
   - qu'on utilise comme photopolymère une résine époxy possédant un poids moléculaire inférieur à 15000, que l'on obtient par transformation d'une résine époxy à base de bisphénol A comportant des groupes terminaux époxy avec un chlorure d'acide 3-(2-furyl)-acrylique,
   - qu'on réalise la réticulation du photopolymère en utilisant une lumière possédant une longueur d'onde située dans la gamme allant de 150 à 400 nm en présence d'un photosensibilisateur et sans thermodurcissement ultérieur, et
   - qu'on forme directement sur la première couche ainsi fabriquée, sans traitement préalable particulier, d'autres couches (strates) de structures de câblage par dépôt du photopolymère et mise en oeuvre des étapes opératoires b) et c).

2. Procédé suivant la revendication 1, caractérisé par le fait que la réticulation est exécutée dans la gamme des longueurs d'onde de 300-400 nm.

3. Procédé suivant la revendication 1 ou 2, caractérisé par le fait qu'on ajoute au polymère photosensible, des sensibilisateurs, des photo-initiateurs et également des cosensibilisateurs, en des concentrations possédant la gamme comprise entre 0,5 et 5 %.

4. Procédé suivant la revendication 3, caractérisé par le fait qu'on utilise des dérivés de benzophénol, benzoïne ou acétophénone et, en tant que cosensibilisateur des amines tertiaires.

5. Procédé suivant la revendication 4, caractérisé par le fait qu'on utilise comme sensibilisateur, une cétone de Michler (4,4'-bis (diméthylamino)-benzophénone).

6. Procédé suivant au moins l'une des revendications 1 à 5, caractérisé par le fait qu'on utilise des diluants réactifs, de préférence à base d'acrylate et dans une gamme de concentrations allant de 5 à 30 % en poids, rapportées au polymère de base.

FIG 1

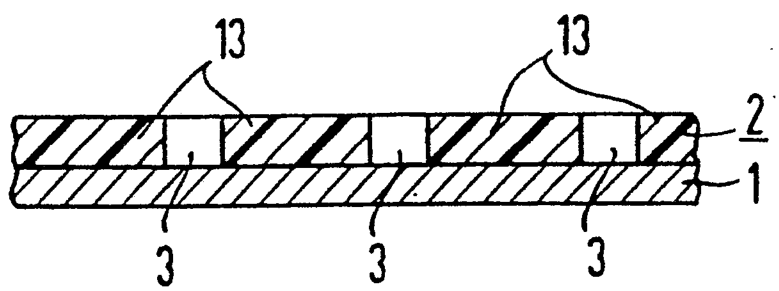


FIG 2